# EUROPÄISCHE PATENTSCHRIFT

(11) **EP 3 414 581 B1**
(45) Veröffentlichungstag und Bekanntmachung des Hinweises auf die Patenterteilung: **01.01.2020**
(21) Anmeldenummer: 17704655.4
(22) Anmeldetag: 06.02.2017
(51) Int. Cl.: G01R 31/26, H05B 33/08, H01L 25/16

(54) **VERFAHREN UND ICT-EINRICHTUNG ZUM ÜBERPRÜFEN VON ZUMINDEST ZWEI LEDS ENTHALTENDEN MODULEN EINER BELEUCHTUNGSEINRICHTUNG**
METHOD AND ICT DEVICE FOR INSPECTING MODULES OF A LIGHTING DEVICE, SAID LIGHTING DEVICE CONTAINING AT LEAST TWO LEDS
PROCÉDÉ ET DISPOSITIF ICT DE CONTRÔLE DE MODULES D'UN DISPOSITIF D'ÉCLAIRAGE QUI CONTIENNENT AU MOINS DEUX LED

(30) Priorität: 11.02.2016 AT 500872016
(43) Veröffentlichungstag der Anmeldung: 19.12.2018
(73) Patentinhaber: ZKW Group GmbH, 3250 Wieselburg (AT)
(72) Erfinder: WEBER, Emanuel, 2500 Baden (AT); ESTERLE, Stefan, 2392 Grub (AT)
(74) Vertreter: Patentanwaltskanzlei Matschnig & Forsthuber OG
(86) Internationale Anmeldenummer: PCT/AT2017/060020
(87) Internationale Veröffentlichungsnummer: WO 2017/136864

(56) Entgegenhaltungen:
- DE-A1-102004 056 705
- US-A1- 2012 063 121
- US-A1- 2012 319 586

## Beschreibung

Die Erfindung bezieht sich auf Verfahren zum Überprüfen von zumindest zwei LEDs enthaltenden LED-Modulen einer Beleuchtungseinrichtung, bei welchem zumindest ein Paar von LEDs eines Moduls ausgewählt wird, eine der beiden LEDs des Paares mit zumindest einer Stromquelle verbunden wird und die andere der beiden LEDs mit zumindest einer elektrischen Messeinrichtung verbunden wird, die eine der beiden LEDs mit einer vorgegebenen Stromstärke bestromt wird und die in der anderen der beiden LEDs erzeugte physikalische Änderung gemessen wird, sodann das Bestromen und Messen an den beiden LEDs des Paares vertauscht wird und das Modul als schadhaft identifiziert wird, falls bei zumindest einer Messung der mittels der Messeinrichtung ermittelte Wert außerhalb eines festlegbaren Bereiches liegt.

Ebenso bezieht sich die Erfindung auf eine ICT-Einrichtung zum Überprüfen von zumindest zwei LEDs enthaltenden Modulen einer Beleuchtungseinrichtung mittels eines erfindungsgemäßen Verfahrens, mit ICT-Adaptermitteln, mit zumindest einer Stromquelle und mit zumindest einer elektrischen Messeinrichtung, wobei das ICT-Adaptermittel Kontaktiermittel zum Kontaktieren von Messpunkten und/oder Lötstellen der LEDs aufweist.

LED-Lichtmodule, im speziellen im Automotive-Bereich, müssen einer Diagnose der Funktionalität unterzogen werden, bevor sie zum Einsatz kommen. Dies bedeutet, dass bei einer Funktionskontrolle nach der Bestückung einer Platine mit LEDs und gegebenenfalls anderen Bauteilen eine Abfrage stattfinden muss, aus welcher der Status der einzelnen LEDs in dem Lichtmodul hervorgeht. Einzelne Lichtmodule bestehen in vielen Fällen aus mehreren, in einem Strang angeordneten LEDs. Die Diagnose solcher LED-Stränge wird nach dem Stand der Technik über eine Strom-Spannungsmessung realisiert. Steigt bzw. sinkt die gemessene Spannung über bzw. unter einen bestimmten Grenzwert, wird eine Fehlfunktion diagnostiziert und es werden die erforderlichen Maßnahmen durchgeführt; beispielsweise wird das entsprechende Modul als Ausschuss gekennzeichnet.

Derartige Diagnosemessungen, die lediglich auf der Messung der elektrischen Parameter der LEDs beruhen, spiegeln jedoch nur die elektrische Funktionsfähigkeit wieder. Sollte im optischen Bereich des Lichtmoduls ein Fehler auftreten, kann dieser nicht diagnostiziert und dementsprechend auch ein schadhaftes Modul nicht ausgeschieden bzw. als defekt markiert werden. Eine Diagnosemöglichkeit nach dem Stand der Technik, welche die tatsächliche optische Funktion des Lichtmoduls bewertet, ist die optische Überprüfung von LEDs im ICT (in-Circuit-Test) bzw. beim EOL (End-of-Line) Test nach der Fertigung. Dabei wird entweder mit Glasfasermodulen, die an einen externen Photodetektor angeschlossen sind, oder mit Kamera-basierten Systemen gearbeitet. Der Nachteil dieser Systeme liegt in den hohen Anschaffungskosten und der nur beschränkten Diagnosemöglichkeit, da üblicherweise in diesen Systemen nur eine Geht/Geht-nicht Überprüfung durchgeführt wird.

Das Dokument US 4,797,609 A zeigt eine Vorrichtung zum Überprüfen eines LED-Arrays mit typischerweise einigen tausenden LEDs, welche zur Belichtung eines fotografischen Films im Sinne der Erzeugung von Bildern mit hoher Auflösung für beispielsweise Luftbildkameras dienen. Die LEDs werden dabei beispielsweise von einer Satellitenkamera digital angesteuert. Weitere Vorrichtungen sind aus US2012/319586, DE102004056705 und US2012/063121 bekannt.

Um diese LEDs auf ihre Funktion, insbesondere ihren Helligkeitswert zu überprüfen, wird mittels eines elektronischen Schalters eine LED ausgewählt und mit einem Strom angesteuert, sodass sie leuchtet. Dabei wird in einer benachbarten LED, die ohne weitere Hilfsmittel offenbar durch diffuses Licht von der angesteuerten LED belichtet wird, ein Strom erzeugt, der gemessen wird. Verständlicherweise setzt dieses bekannte Überprüfungsverfahren eine enge Nachbarschaft der zu überprüfenden LEDs voraus, die zwar bei den speziellen Arrays nicht jedoch bei Lichtmodulen im Allgemeinen gegeben ist. Eine Aufgabe er Erfindung liegt in der Schaffung eines Verfahrens, welches kostengünstig eine verlässliche Prüfung der LEDs eines LED-Lichtmoduls gestattet. Ebenso liegt eine Aufgabe der Erfindung darin, eine zur Durchführung eines entsprechenden Verfahrens geeigneten ICT-Einrichtung bereitzustellen, welche ohne großen Aufwand hergestellt werden kann.

Zur Lösung der genannten Aufgaben sieht die Erfindung ein Verfahren der eingangs genannten Art vor, bei welchem erfindungsgemäß die beiden LEDs eines Paares über einen Lichtwellenleiter optisch miteinander verbunden werden.

Eine zweckmäßige Ausbildung der Erfindung zeichnet sich dadurch aus, dass bei LED-Modulen mit mehr als zwei LEDs die Verfahrensschritte auf sämtliche mögliche Paare von LEDs angewendet wird.

Auch kann man mit Vorteil vorsehen, dass bei LED-Modulen mit mehr als einem Paar von LEDs zwei oder mehr Lichtwellenleiter zum optischen Verbinden von je zwei LEDs verwendet werden.

Besonders zweckmäßig ist es weiters, wenn zum Verbinden von auf einer Platine angeordneten LEDs mit der zumindest einen Stromquelle und mit der zumindest einen Messeinrichtung ein ICT-Adapter eingesetzt wird, um Messpunkte und/oder Lötstellen der LEDs zu kontaktieren und um die optische Verbindung über einen Lichtwellenleiter herzustellen.

Eine weitere empfehlenswerte Ausbildung der Erfindung sieht vor, dass die beiden Enden des Lichtwellenleiters zentriert in den Nahbereich der elektro-optisch aktiven Bereiche der beiden LEDs des zumindest einen Paars von LEDs gebracht werden.

Besonders vorteilhaft ist es, wenn mittels der Messeinrichtung Strom und/oder Spannung gemessen werden.

Die Aufgabe wird auch mit einer ICT-Einrichtung der oben genannten Art gelöst, bei welcher die ICT-Adaptermittel zumindest einen Lichtwellenleiter zur optischen Verbindung von je zwei LEDs aufweist.

Dabei ist es vorteilhaft, wenn der zumindest eine Lichtwellenleiter als optische Faserleitung ausgebildet ist.

Eine andere empfehlenswerte Variante sieht vor, dass der zumindest eine Lichtwellenleiter als lichtleitender U-förmiger Stab ausgebildet ist.

Es kann auch zweckmäßig sein, wenn zwei oder mehr Lichtwellenleiter für auf einer Platine sitzende LEDs vorgesehen sind.

Eine besonders empfehlenswerte Ausbildung sieht vor, dass die Messeinrichtung eine Strom/Spannungsmesseinrichtung ist.

Die Erfindung samt weiteren Vorteilen ist im Folgenden an Hand beispielsweiser Ausführungen näher erläutert, die in der Zeichnung veranschaulicht sind. In dieser zeigen
Fig. 1 in perspektivischer Darstellung ein LED-Modul samt Leiterplatte und einem darüber befindlichen ICT-Adapter einer ICT-Messeinrichtung nach der Erfindung,
Fig. 2 eine Darstellung wie Fig. 1 jedoch mit einem auf die Leiterplatte abgesenkten und kontaktierten ICT-Adapter,
Fig. 3 in einem schematischen Schaltbild das Überprüfen von vier in Serie geschalteten LEDs,
Fig. 4 bis 6 bzw. Fig. 4a bis 6a je in Seitenansicht bzw. in Draufsicht drei Schritte der Überprüfung eines Moduls mit vier LEDs.

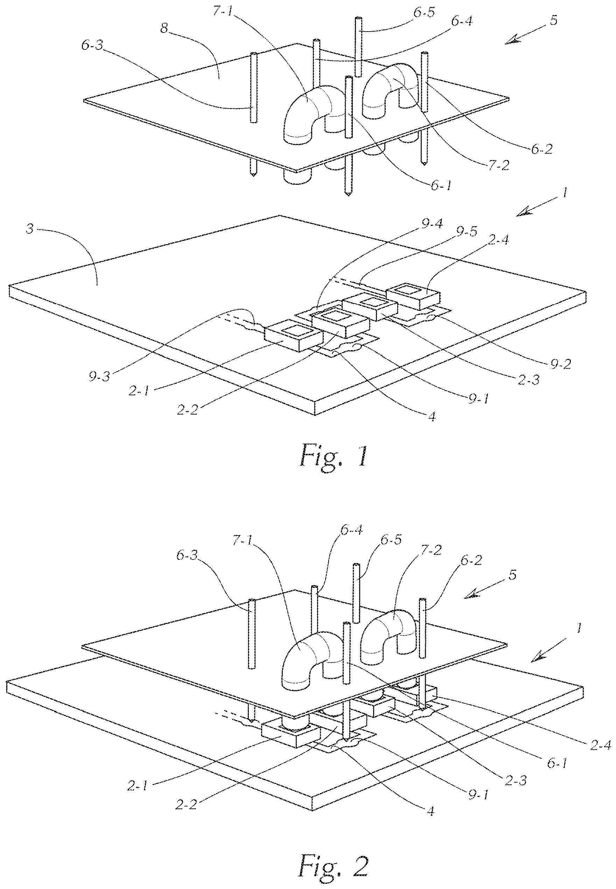

Fig. 1 zeigt ein LED-Modul 1, das bei diesem Beispiel vier LEDs 2-1, 2-2, 2-3 und 2-4 aufweist, die auf einer Leiterplatte 3 angeordnet und über Leiterbahnen 4 miteinander verbunden sind, wobei die LEDs im Allgemeinen und wie hierdargestellt in Serie geschaltet sind. Ein solches LED-Modul kann insbesondere in einem Fahrzeugscheinwerfer zum Einsatz kommen.

Wie weiter oben bereits erläutert, müssen LED-Module vor dem Einsatz auf korrekte Funktion überprüft werden. Dazu dient ein sogenannter ICT (In Circuit Test) bzw. eine entsprechende ICT-Einrichtung mit geeigneten Adaptermitteln, von welchen in Fig. 1 ein für die Durchführung des Verfahrens nach der Erfindung geeigneter ICT-Adapter 5 gezeigt ist.

Der als Beispiel gezeigte ICT-Adapter 5 weist hier fünf Messstifte 6-1 bis 6-5 auf sowie zwei U-förmige Lichtleiter 7-1, 7-2 mit in der Zeichnung nach unten gerichteten, meist planen Endflächen für einen Lichteintritt bzw. Lichtaustritt.

Die Messstifte 6-1 bis 6-5 und die Lichtleiter 7-1, 7-2 sind auf einem schematisch dargestellten Träger 8 befestigt und so angeordnet, dass mit Hilfe der Lichtleiter 7-1, 7-2 je zwei LEDs 2-1, 2-2 bzw. 2-3, 2-4 optisch miteinander verbunden werden können, wenn der ICT-Adapter 5 mit dem LED-Modul 1 in Kontakt gebracht wird, wozu auf die Darstellung der Fig. 2 verwiesen wird. In dieser kontaktierten Stellung greifen die Messstifte 6-1 bis 6-5 an Messpunkten 9-1 bis 9-5 der Leiterbahnen 4 an. Um den gewünschten elektrischen Kontakt sicher zu stellen, müssen die Messpunkte von allenfalls vorhandenem Lötstopplack freigestellt sein. Die Messstifte 6-1 bis 6-5 bestehen natürlich aus leitendem Material und sind in auf weiter unten beschriebener Weise mit zumindest einer Stromquelle und mit zumindest einer elektrischen Messeinrichtung verbunden.

Der ICT-Adapter 5 wird zur Überprüfung des LED-Moduls 1 mit einer bestimmten Kraft gegen das Modul 1 gedrückt, die ausreicht, um einen sicheren elektrischen Kontakt zu gewährleisten. Dabei müssen die Endflächen der U-förmigen Lichtleiter 7-1, 7-2 zwar nicht zwingend in physischen Kontakt mit den LEDs kommen, doch sollen sie zentriert in den Nahbereich der elektro-optisch aktiven Bereiche der LEDs gelangen.

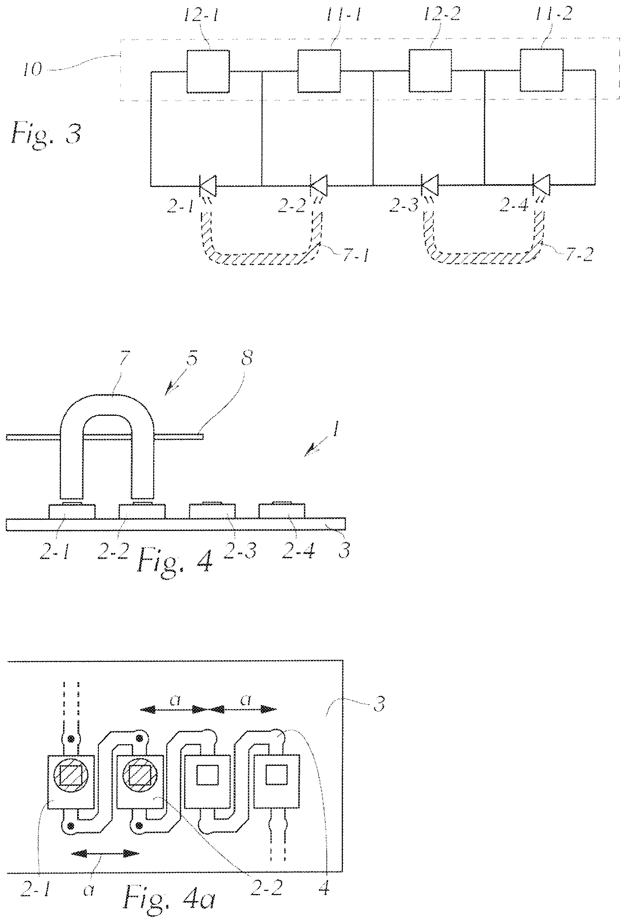

Nun auf Fig. 3 Bezug nehmend, wird näher erläutert, dass zur Ausführung des erfindungsgemäßen Verfahrens, ausgehend von der kontaktierten Lage des LED-Moduls 1 und dem ICT-Adapter, jeweils eine der zwei optisch über einen Lichtleiter verbundenen LEDs als Lichtquelle und die zweite als Photodetektor verwendet wird. Die Stromversorgung sowie die Messung erfolgt über die Messstifte 6-1 bis 6-5.

Die Erfindung beruht auf der Idee, dass optische Pfade, im gezeigten Beispiel die U-förmigen Lichtleiter, zwischen den einzelnen LEDs für das Einbringen von Licht von einer LED zu einer anderen während des Funktionstests angeordnet werden. Eine LED dient dabei als Lichtquelle und an der anderen stellt sich wie bei einer Fotodiode eine zum Lichtstrom proportionale Spannung ein. Somit wird eine LED in Vorwärtsrichtung betrieben und im PN-Übergang des Halbleiters werden Photonen erzeugt. Andererseits werden bei der anderen LED, die nicht aktiv bestromt wird, auf den PN-Übergang eintreffende Photonen in elektrische Energie umgewandelt.

In Fig. 3 ist die Serienschaltung von vier LEDs 2-1, 2-2, 2-3 und 2-4 eines Moduls, z.B. des Moduls 1 der Fig. 1 und 2, gezeigt, wobei zwischen den LEDs 2-1 und 2-2 einerseits und 2-3 und 2-4 andererseits in Position gebrachte Lichtleiter 7-1 und 7-2 schematisch gezeigt sind.

Über die Messstifte, die Messpunkte und die Leiterbahnen können die Anschlüsse der LEDs vorübergehend mit einer schematisch eingezeichneten Kontrolleinrichtung 10 verbunden werden, wobei diese auch nicht dargestellte Schaltmittel besitzt, um die entsprechend ausgewählten LEDs auch mit zumindest einer elektrischen Messeinrichtung zu verbinden. Die Kontrolleinrichtung 10 wird im Allgemeinen auch einen Mikrocomputer aufweisen, der den gesamten Ablauf der Bestromung der LEDs, der Messung sowie das Bewegen des ICT-Adapters steuert.

In dem in Fig. 3 gezeigten Zustand sind die LEDs 2-2 und 2-4 an Stromquellen 11-1 und 11-2 und die LEDs 2-1 und 2-3 an elektrische Messeinrichtungen 12-1 und 12-2 angeschlossen, welche bevorzugt zur Spannungs- oder Strommessung eingerichtet bzw. geeignet sind. Ganz allgemein können physikalische Änderungen der LEDs gemessen werden, wie beispielsweise die Kapazität, welche von der Stärke und/oder Dauer des Lichteinfalls abhängt.

Prinzipiell läuft das Verfahren nach der Erfindung so ab, dass zumindest ein Paar von LEDs eines Moduls ausgewählt wird, im gezeigten Beispiel die LED-Paare 2-1, 2-2 und 2-3, 2-4 und dann die beiden LEDs dieses Paares über einen Lichtwellenleiter, hier die Lichtleiter 7-1, 7-2, optisch miteinander verbunden werden.

Daraufhin wird eine der beiden LEDs des Paares, hier sind es die LEDs 2-2, 2-4, mit zumindest einer Stromquelle 11-1, 11-2 verbunden und die andere der beiden LEDs 2-1, 2-3 mit zumindest einer elektrischen Messeinrichtung 12-1, 12-2 verbunden.

Jeweils eine der beiden LEDs 2-2, 2-4 wird nun mit einer vorgegebenen Stromstärke bestromt und die in der jeweils anderen der beiden LEDs 2-1, 2-3 erzeugte physikalische Änderung wird gemessen. Im Folgenden wird das Bestromen und Messen an den beiden LEDs des Paares vertauscht und das Modul wird als schadhaft identifiziert, falls bei zumindest einer Messung der mittels der Messeinrichtung bzw. Messeinrichtungen ermittelte Wert, z.B. eine gemessene Spannung, außerhalb eines festlegbaren Bereiches liegt. Der Begriff "Bereich" soll beliebige Bereiche umfassen, auch nach oben oder unten offene Bereiche. Beispielsweise kann man die Spannung an der nicht bestromten LED eines Paares messen und das Modul dann als schadhaft identifizieren, wenn der gemessene Spannungswert unterhalb eines festgelegten Spannungspegels liegt. Auch kann der Bereich sehr eng gewählt sein, sodass der gemessene Wert innerhalb der jeweiligen Messgenauigkeit praktisch diesem Wert entsprechen muss, anderenfalls von einem schadhaften Modul auszugehen ist.

An Hand des Beispiels der Fig. 4 bis 6 bzw. Fig. 4a bis 6a wird ein solcher Messvorgang genauer veranschaulicht.

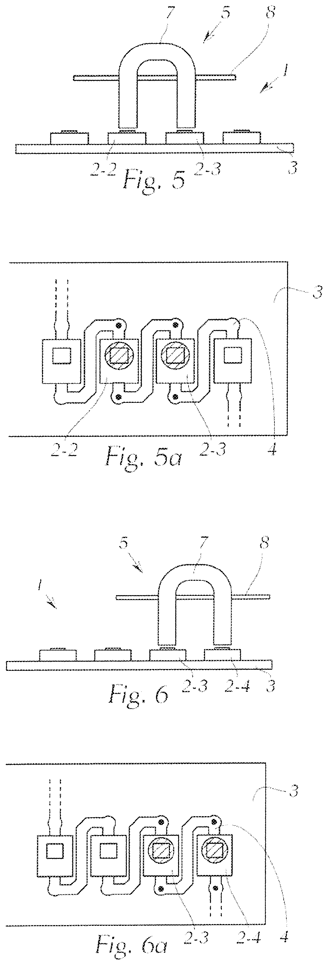

Der ICT-Adapter 5 ist verschiebbar ausgeführt, um so für ein LED-Modul 1 mit mehr als zwei LEDs, gezeigt sind wieder vier LEDs 2-1, 2-2, 2-3 und 2-4, lediglich einen Lichtleiter 7, sowie eine Messeinrichtung und eine Stromquelle zu benötigen. Dementsprechend verwendet man hier vier Messstifte, die in dieser Figur ebenso nicht gezeigt sind, wie die Messeinrichtung und die Stromquelle. Dabei wird wie ersichtlich der ICT-Adapter 5 mit dem Lichtleiter 7 und den Messstiften von einem LED-Paar - in Fig. 4 und 4a die LEDs 2-1 und 2-2 zum nächsten - in Fig. 5 und 5a die LEDs 2-2, 2-3 und in Fig. 6 und 6a die LEDs 2-3, 2-4 weitergeführt. Vorteilhafter Weise sind die weiter oben erläuterten Messpunkte auf der Leiterplatte 3 sowie die LEDs 2-1, 2-2, 2-3 und 2-4 des LED-Moduls 1 so angeordnet bzw. ist deren Abstand - siehe die Pfeile a in Fig. 4a - zueinander so ausgelegt dass es mit lediglich vier Messstiften und einem Lichtleiter möglich ist, das Verfahren für die vier gezeigten LEDs des LED-Moduls auszuführen. Die Schraffierungen in den Fig. 4a, 5a und 6a bezeichnen die jeweils ausgewählten LED-Paare und die Punkte auf den Leiterbahnen die dabei verwendeten Kontaktierungspunkt der Messstifte:

Bei entsprechender Auslegung der Leiterbahnen ist es auch möglich, lediglich drei Messstifte zu verwenden, da es die Beschaltung, wie in Fig. 3 ersichtlich, erlaubt, einen Kontakt für die Messeinrichtung und die Stromversorgung gemeinsam zu verwenden. Damit könnte man beispielsweise einen Kontakt zwischen zwei LEDs mit einem Messstift kontaktieren und außerhalb des ICT-Adapters 5 auf die jeweiligen Messeinrichtungen bzw. Stromquellen aufteilen.

Es ist aber auch weiters möglich, die Anordnung der LEDs und der zugehörigen Leiterbahnen so zu gestalten, dass zwar nur ein Lichtleiter jedoch mehrere Messstifte benötigt werden. Ein solcher Fall liegt vor, falls die Entflechtung der Leiterplatte keinen Verlauf der Leiterbahnen, wie er in den Figuren dargestellt ist, zulässt. Ebenso ist es möglich lediglich drei oder vier Messstifte zu verwenden, jedoch mehrere Lichtleiter anzuwenden, da unter Umständen in gleicher Weise die LEDs im LED-Modul lichttechnisch bedingt keinen regelmäßigen Abstand aufweisen können.

Man erkennt, dass das in den Fig. 4 bis 6a skizzierte Verfahren besonders zweckmäßig ist, da der Bauteilaufwand sowohl am Adapter 5 als auch bei der Kontrolleinrichtung 10 gering gehalten werden kann.

Der Umstand, dass jede LED sowohl als Lichtquelle als auch als Photodetektor verwendet wird, führt naturgemäß zu einer besonders hohen Sicherheit der Überprüfung mit erhöhter Fehlerdetektionsrate.

## Patentansprüche

1. Verfahren zum Überprüfen von zumindest zwei LEDs (2-1 ... 2-4) enthaltenden LED-Modulen (1) einer Beleuchtungseinrichtung, bei welchem zumindest ein Paar (2-1, 2-2; 2-3, 2-4) von LEDs eines Moduls (1) ausgewählt wird,
eine (2-2; 2-4) der beiden LEDs des Paares mit zumindest einer Stromquelle (11-1; 11-2) verbunden wird und die andere (2-1; 2-3) der beiden LEDs mit zumindest einer elektrischen Messeinrichtung (12-1; 12-2) verbunden wird,
die eine der beiden LEDs mit einer vorgegebenen Stromstärke bestromt wird und die in der anderen der beiden LEDs erzeugte physikalische Änderung gemessen wird,
sodann das Bestromen und Messen an den beiden LEDs des Paares vertauscht wird
und das Modul als schadhaft identifiziert wird, falls bei zumindest einer Messung der mittels der Messeinrichtung ermittelte Wert außerhalb eines festlegbaren Bereiches liegt,
**dadurch gekennzeichnet, dass**
die beiden LEDs (2-1; 2-2) eines Paares über einen Lichtwellenleiter (7-1; 7-2) optisch miteinander verbunden werden.

2. Verfahren nach Anspruch 1, **dadurch gekennzeichnet, dass** bei LED-Modulen (1) mit mehr als zwei LEDs (2-1 ... 2-4) die Verfahrensschritte auf sämtliche mögliche Paare von LEDs angewendet wird.

3. Verfahren nach einem Anspruch 1 oder 2, **dadurch gekennzeichnet, dass** bei LED-Modulen (1) mit mehr als einem Paar von LEDs (2-1 ... 2-4) zwei oder mehr Lichtwellenleiter (7-1; 7-2) zum optischen Verbinden von je zwei LEDs verwendet werden.

4. Verfahren nach einem der Ansprüche 1 bis 3, **dadurch gekennzeichnet, dass** zum Verbinden von auf einer Platine (3) angeordneten LEDs (2-1 ... 2-4) mit der zumindest einen Stromquelle (11-1; 11-2) und mit der zumindest einen Messeinrichtung (12-1; 12-2) ein ICT-Adapter (5) eingesetzt wird, um Messpunkte (9-1 ... 9-5) und/oder Lötstellen der LEDs zu kontaktieren und um die optische Verbindung über den Lichtwellenleiter (7; 7-1, 7-2) herzustellen.

5. Verfahren nach einem der Ansprüche 1 bis 4, **dadurch gekennzeichnet, dass** die beiden Enden des Lichtwellenleiters (7; 7-1, 7-2) zentriert in den Nahbereich der elektro-optisch aktiven Bereiche der beiden LEDs (2-1, 2-2; 2-3, 2-4) des zumindest einen Paars von LEDs gebracht werden.

6. Verfahren nach einem der Ansprüche 1 bis 5, **dadurch gekennzeichnet, dass** mittels der Messeinrichtung (12-1, 12-2) Strom und/oder Spannung gemessen werden.

7. In-Circuit-Test (ICT)-Einrichtung zum Überprüfen von zumindest zwei LEDs (2-1 ... 2-4) enthaltenden Modulen (1) einer Beleuchtungseinrichtung mittels eines Verfahrens nach einem der Ansprüche 1 bis 7, mit ICT-Adaptermitteln (5), mit zumindest einer Stromquelle (11-1, 11-2) und mit zumindest einer elektrischen Messeinrichtung (12-1; 12-2), wobei das ICT-Adaptermittel Kontaktiermittel (6-1 ... 6-5) zum Kontaktieren von Messpunkten (9-1 ... 9-5) und/oder Lötstellen der LEDs aufweist,
**dadurch gekennzeichnet, dass**
die ICT-Adaptermittel (5) zumindest einen Lichtwellenleiter (7; 7-1, 7-2) zur optischen Verbindung von je zwei LEDs (2-1, 2-2; 2-3, 2-4) aufweist.

8. ICT-Einrichtung nach Anspruch 7, **dadurch gekennzeichnet, dass** der zumindest eine Lichtwellenleiter als optische Faserleitung ausgebildet ist.

9. ICT-Einrichtung nach Anspruch 7, **dadurch gekennzeichnet, dass** der zumindest eine Lichtwellenleiter (7) als lichtleitender U-förmiger Stab ausgebildet ist.

10. ICT-Einrichtung nach einem der Ansprüche 7 bis 9, **dadurch gekennzeichnet, dass** zwei oder mehr Lichtwellenleiter (7-1, 7-2) für auf einer Platine (3) sitzende LEDs (2-1 ... 2-4) vorgesehen sind.

11. ICT-Einrichtung nach einem der Ansprüche 7 bis 10, **dadurch gekennzeichnet, dass** die Messeinrichtung (12-1, 12-2) eine Strom/Spannungsmesseinrichtung ist.

## Claims

1. A method for checking LED modules (1), containing at least two LEDs (2-1 ... 2-4), of a lighting device, in which at least one pair (2-1, 2-2; 2-3, 2-4) of LEDs of a module (1) is selected,
one (2-2; 2-4) of the two LEDs of the pair is connected to at least one current source (11-1; 11-2) and the other (2-1; 2-3) of the two LEDs is connected to at least one electrical measuring device (12-1; 12-2),
the one of the two LEDs is powered with a predetermined current intensity and the physical change generated in the other of the two LEDs is measured,
then the powering and measurement at both LEDs of the pair is swapped
and the module is identified as defective if the value determined by means of the measuring device lies outside of a determinable range in at least one measurement,
**characterized in that**
the two LEDs (2-1; 2-2) of a pair are optically connected to one another via an optical waveguide (7-1; 7-2).

2. The method according to Claim 1, **characterized in that** for LED modules (1) having more than two LEDs (2-1 ... 2-4), the method steps are applied to all possible pairs of LEDs.

3. The method according to Claim 1 or 2, **characterized in that** for LED modules (1) having more than one pair of LEDs (2-1 ... 2-4), two or more optical waveguides (7-1; 7-2) are used for optically connecting two LEDs in each case.

4. The method according to one of Claims 1 to 3, **characterized in that** an ICT adapter (5) is used for connecting LEDs (2-1 ... 2-4) arranged on a printed circuit part (3) to the at least one current source (11-1; 11-2) and to the at least one measuring device (12-1; 12-2), in order to contact measuring points (9-1 ... 9-5) and/or soldering points of the LEDs and in order to produce the optical connection via the optical waveguide (7; 7-1, 7-2).

5. The method according to one of Claims 1 to 4, **characterized in that** the two ends of the optical waveguide (7; 7-1, 7-2) are brought, in a centred manner, within close range of the electro-optically active regions of the two LEDs (2-1, 2-2; 2-3, 2-4) of the at least one pair of LEDs.

6. The method according to one of Claims 1 to 5, **characterized in that** current and/or voltage are measured by means of the measuring device (12-1, 12-2) .

7. An in-circuit-test (ICT) device for checking modules (1), containing at least two LEDs (2-1 ... 2-4), of a lighting device by means of a method according to one of Claims 1 to 7, having ICT adapter means (5), having at least one current source (11-1, 11-2) and having at least one electrical measuring device (12-1; 12-2), the ICT adapter means having contacting means (6-1 ... 6-5) for contacting measuring points (9-1 ... 9-5) and/or soldering points of the LEDs,
**characterized in that**
the ICT adapter means (5) has at least one optical waveguide (7; 7-1, 7-2) for optically connecting two LEDs (2-1, 2-2; 2-3, 2-4) in each case.

8. The ICT device according to Claim 7, **characterized in that** the at least one optical waveguide is constructed as an optical fibre cable.

9. The ICT device according to Claim 7, **characterized in that** the at least one optical waveguide (7) is constructed as a light-conductive U-shaped rod.

10. The ICT device according to one of Claims 7 to 9, **characterized in that** two or more optical waveguides (7-1, 7-2) are provided for LEDs (2-1 ... 2-4) sitting on a printed circuit board (3).

11. The ICT device according to one of Claims 7 to 10, **characterized in that** the measuring device (12-1, 12-2) is a current/voltage measuring device.

## Revendications

1. Procédé de contrôle d'au moins deux modules DEL (1) contenant au moins deux DELs (2-1 ... 2-4) d'un dispositif d'éclairage, dans lequel au moins une paire (2-1, 2-2 ; 2-3,2-4) de DELs d'un module (1) est sélectionnée,
une (2-2 ; 2-4) des deux DELs de la paire est reliée avec au moins une source de courant (11-1 ; 11-2) et l'autre (2-1 ; 2-3) des deux DELs est reliée avec au moins un dispositif de mesure électrique (12-1 ; 12-2),
une des deux DELs est mise sous tension avec une intensité de courant prescrite et la variation physique générée dans l'autre des deux DELs est mesurée,
après quoi la mise sous tension et la mesure sur les deux DELs de la paire est intervertie, et le module est identifié comme défectueux, au cas où lors d'au moins une mesure la valeur déterminée au moyen du dispositif de mesures est située en dehors d'une plage prescrite,
**caractérisé en ce que**
les deux DELs (2-1 ; 2-2) d'une paire sont reliées optiquement l'une à l'autre par l'intermédiaire d'un conducteur à fibre optique (7-1 ; 7-2).

2. Procédé selon la revendication 1, **caractérisé en ce que** dans le cas des modules DEL (1) avec plus de deux DELs (2-1 ... 2-4) les étapes de procédé sont appliquées sur toutes les paires possibles de DELs.

3. Procédé selon la revendication 1 ou 2, **caractérisé en ce que** dans le cas des modules DEL (1) avec plus d'une paire de DELs (2-1 ... 2-4) deux ou plus conducteurs à fibre optique (7-1 ; 7-2) pour la liaison optique de respectivement deux DELs sont utilisés.

4. Procédé selon une des revendications 1 à 3, **caractérisé en ce que** pour relier des DELs (2-1 ... 2-4) disposées sur une platine (3) avec au moins une source de courant (11-1 ; 11-2) et avec au moins un dispositif de mesure (12-1 ; 12-2) un adaptateur ICT (5) est employé, afin de contacter les points de mesure (9-1 ... 9-5) et/ou les points de brasage des DELs et établir la liaison optique par l'intermédiaire du conducteur à fibre optique (7 ; 7-1, 7-2).

5. Procédé selon une des revendications 1 à 4, **caractérisé en ce que** les deux extrémités du conducteur à fibre optique (7 ; 7-1, 7-3) sont appliquées de manière centrée à proximité de la plage active électro-optique des deux DELs (2-1, 2-2 ; 2-3, 2-4) d'au moins une paire de DELs.

6. Procédé selon une des revendications 1 à 5, **caractérisé en ce que** au moyen du dispositif de mesure (12-1, 12-2) du courant et/ou de la tension est mesurée.

7. Dispositif de circuit de test (ICT) pour contrôler au moins deux modules (1) contenant des DELs (2-1 ... 2-4) d'un dispositif d'éclairage au moyen d'un procédé selon une des revendications 1 à 7, comportant des moyens d'adaptateur ICT (5), comportant au moins une source de courant (11-1, 11-2) et comportant au moins un dispositif de mesure électrique (12-1 ; 12-2), dans lequel le moyen d'adaptateur ICT présente des moyens de contact (6-1 ... 6-5) pour contacter des points de mesure (9-1 ... 9-5) et/ou des points de brasage des DELs,
**caractérisé en ce que**
le moyen d'adaptateur ICT (5) présente au moins un conducteur à fibre optique (7 ; 7-1, 7,2) pour la liaison optique de respectivement deux DELs (2-1, 2-2 ; 2-3, 2-4).

8. Dispositif ICT selon la revendication 7, **caractérisé en ce que** au moins un conducteur à fibre optique est configuré comme une ligne de fibre optique.

9. Dispositif ICT selon la revendication 7, **caractérisé en ce que** au moins un conducteur à fibre optique (7) est configuré comme une barre en forme de U conductrice de lumière.

10. Dispositif ICT selon une des revendications 7 à 9, **caractérisé en ce que** deux ou plus conducteurs à fibre optique (7-1 ; 7-2) sont prévus pour des DELs (2-1 ... 2-4) reposant sur une platine.

11. Dispositif ICT selon une des revendications 7 à 10, **caractérisé en ce que** le dispositif de mesure (12-1, 12-2) est un dispositif de mesure de courant/tension.
